# EUROPÄISCHE PATENTSCHRIFT

(11) **EP 2 852 972 B1**
(45) Veröffentlichungstag und Bekanntmachung des Hinweises auf die Patenterteilung: **24.02.2016**
(21) Anmeldenummer: 12727150.0
(22) Anmeldetag: 12.06.2012
(51) Int. Cl.: H01L 21/68, H01L 21/67

(54) **VORRICHTUNG UND VERFAHREN ZUM AUSRICHTEN VON SUBSTRATEN**
APPARATUS AND METHOD FOR ALIGNING SUBSTRATES
APPAREIL ET PROCEDE D'ORIENTATION DE SUBSTRATS

(43) Veröffentlichungstag der Anmeldung: 01.04.2015
(73) Patentinhaber: Thallner, Erich, 4782 St. Florian (AT)
(72) Erfinder: Thallner, Erich, 4782 St. Florian (AT)
(74) Vertreter: Schweiger, Johannes
(86) Internationale Anmeldenummer: PCT/EP2012/061109
(87) Internationale Veröffentlichungsnummer: WO 2013/185803

(56) Entgegenhaltungen:
- JP-A- 2011 233 683
- US-A1- 2003 226 633

## Beschreibung

Die vorliegende Erfindung betrifft eine Vorrichtung zum Ausrichten und Kontaktieren eines flächigen Substrats mit einem Trägersubstrat für die Weiterverarbeitung des Substrats nach Anspruch 1 sowie ein korrespondierendes Verfahren nach Anspruch 7.

Die JP 2011 2336683 A offenbart eine Bondingvorrichtung und die US 2003/226633 A1 offenbart eine Vorrichtung und ein Verfahren zur Herstellung von gebondeten Substraten.

Das Rückdünnen von Wafern ist in der Halbleiterindustrie häufig erforderlich und kann mechanisch und/oder chemisch erfolgen. Zum Rückdünnen werden die Wafer in der Regel auf einem Trägersystem vorübergehend fixiert, wobei es bei der Fixierung verschiedene Methoden gibt. Als Trägersystem werden beispielsweise Folien oder Wafer aus Silizium, Siliziumlegierungen wie SiC, SiN etc., Keramiken, (glasfaserverstärkten) Kunststoffen, Graphit, Saphir, Metallen, Gläsern oder Verbundwerkstoffen verwendet. Am Ende des Rückdünnvorganges und der Nachbearbeitung werden die rückgedünnten Wafer auf Filmrahmen montiert und anschließend wird der Träger entfernt.

Sobald eine über das Rückdünnen hinausgehende Bearbeitung des Substrates nötig ist, kommen wiederum starre Trägersysteme, nämlich Trägersubstrate, zum Einsatz. Beispiele für solche Bearbeitungsschritte auf entsprechenden Industrieanlagen nach dem Rückdünnen sind: Metallisierung, Trockenätzen, Nassätzen, Laserbearbeitung, Lithographie, Ofenprozesse, Dotierung etc.

Bei einem starren Trägersubstrat wird das zu bearbeitende Produktsubstrat typischerweise durch eine Klebeschicht mit dem Trägersubstrat verbunden.

Das Trägersubstrat soll dem beliebig dünnen zu bearbeitenden Substrat ausreichend mechanische Stabilität verleihen, um in weiterführenden Prozessschritten beziehungsweise Prozessvorrichtungen bearbeitet werden zu können. Zieldicken sind heutzutage im Falle einer temporären Verbindung: zwischen 30 und 100 µm, in Zukunft werden dünnere Produktsubstrate angestrebt zwischen 1 µm und 50 µm, im Falle einer permanenten Verbindung sind noch dünnere Produktsubstrate möglich welche physisch nur noch durch die Anforderungen an die Bauhöhe eines Transistors mit Verbindungen limitiert sind. Die minimalen Dicken eines Produktsubstrats liegen zwischen 0,001 µm und 5 µm.

Einige der vorgenannten Bearbeitungsschritte erfordern eine exakte Positionierung der Substrate beziehungsweise des Trägers innerhalb der entsprechenden Vorrichtungen.

Dabei werden beispielsweise werden Produktsubstrate mit nominell 300 mm +/- 200µm auf Trägersubstrat mit 301 mm +/-200µm gebondet. Dies geschieht aus Vorsichtsmaßnahme, um den rückzudünnenden oder rückgedünnten Wafer im Randbereich ausreichend zu schützen und insbesondere zu unterstützen. Durch diese Maßnahme liegt das Trägersubstrat im Randbereich bei verschiedenen Bearbeitungsschritten, insbesondere bei Sputtervorgängen, galvanischer Abscheidung, Ätzprozessen, allerdings frei.

Durch die, im Stand der Technik erwähnten Trägersubstrate kommt es zu einigen Problemen. Abscheidungsprozesse, Anätzungen am Rande des Trägersubstrats etc. führen dazu, dass die Trägersubstratkante stark verunreinigt wird.

Nach dem Ablösen vom Produktsubstrat muss dieser kontaminierte Randbereich sehr aufwendig und kostenintensiv gereinigt werden. Oft ist die defekte Trägersubstratkante der einzige Grund, welcher die Lebensdauer des Trägersubstrats beschränkt. Die Zusatzkosten für ein Endprodukt ergeben sich unter anderem aus den Kosten des Trägersubstrats, dessen Recyclingkosten und der Anzahl der Wiederverwendungszyklen. Durch dieses bisher angewandte Verfahren wird ein Reinigungsschritt des Trägersubstrats sehr teuer, so dass in vielen Fällen das Trägersubstrat nicht wiederverwendet wird.

Je günstiger das Trägersubstrat desto weniger kritisch ist eine geringe Anzahl Wiederverwendungszyklen, beispielsweise sind mindestens zehn Wiederverwendungen für Trägersubstratherstellkosten um 20€ gewünscht.

Je teurer der Trägersubstrat desto wichtiger ist seine hohe Lebensdauer (=große Anzahl von Wiederverwendungszyklen). Beispielsweise sind 1000 Wiederverwendungen für Trägersubstratherstellkosten um 2000€ gewünscht.

Eigenschaften die ein Trägersubstrat in der ersten Herstellung teuer machen können sind z.B.:
- Ausgangsmaterial,
- Präzise Geometrie: Geringes TTV (Total Thickness Variation), z.B. <1µm erforderlich um das Produkt möglichst präzise auf die gewünschte Dicke schleifen und polieren zu können,
- Vorbehandlungen die ein nachfolgendes Lösen des Temporären Bonds ermöglichen.

Durch diese Probleme werden sehr teure Trägersubstrate häufig überhaupt nicht angewendet, obwohl sie für andere Prozessschritte nützliche Eigenschaften hätten.

Bei den nachfolgend aufgeführten Prozessschritten bestehen sehr hohe Anforderungen an die Genauigkeit der Zuordnung zweier Wafer gefordert:
- Bei Plasmabearbeitung rückgedünnter Wafer auf Trägersubstraten bewirkt eine Exzentrizität eine Entladungsungleichmäßigkeit des Plasmas. Entstehende Entladungen (Durchschläge aufgrund hoher elektrischer Felddichte - Arcing) können Schäden an Produkt und Plasmaprozesskammer verursachen. Durch die Möglichkeit ein Trägersubstrat gleich/kleiner als den Produktsubstrat zu verwenden werden besondere Vorteile bei Plasma und Sputterprozessen erreicht.
- Bei der lithografischen Belichtung auf sogenannten Scannern und Steppern werden unzureichend justierte Bondpaare nicht ausreichend genau geladen. Die Referenzierung (Vorausrichtung) des Bondpaars erfolgt aufgrund der Außenkontur. Die Außenkontur eines (viel) größeren Trägersubstrats korrespondiert jedoch nicht mit der Lage der Passmarken auf dem Produktsubstrat solange die Justierung der beiden Außenkonturen nicht präzise ist, bzw. die Außenkontur des Produktsubstrats nicht verwendet werden kann. Die Passmarken sind damit nicht im "Fangbereich" der Mikroskope und müssen aufwendig gesucht werden. Das führt zu Zeit-, Durchsatz- und Produktivitätsverlust an diesen Systemen.

Aufgabe der vorliegenden Erfindung ist es daher, eine Vorrichtung und ein Verfahren zum Ausrichten und Kontaktieren von Substraten anzugeben, mit dem eine genauere und effizientere Ausrichtung und Kontaktierung von Substraten mit einem Trägersubstrat ermöglicht wird.

Diese Aufgabe wird mit den Merkmalen der Ansprüche 1 und 7 gelöst.

Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Der Erfindung liegt der Gedanke zugrunde, durch, insbesondere elektronische, Erfassung (Erfassungsmittel) von Außenkonturen der auszurichtenden und kontaktierenden Substrate sowie Verarbeitung (Steuerungsmittel) der erfassten Außenkonturen in Steuerungssignale zur Ausrichtung (Ausrichtungsmittel) der Substrate eine exaktere Ausrichtung zu erreichen. Dabei ist es erfindungsgemäß insbesondere möglich, dass die Ausrichtung während eines Aufeinander-zu-Bewegens zur Kontaktierung der Substrate, vorzugsweise kontinuierlich erfolgt. Darüber hinaus ist es erfindungsgemäß insbesondere denkbar, die Ausrichtungsgenauigkeit mit denselben Erfassungsmitteln zu überprüfen und gegebenenfalls eine erneute Ausrichtung durchzuführen.

Unter Substraten werden in der Halbleiterindustrie verwendete Produkt- oder Trägersubstrate verstanden. Das Trägersubstrat dient als Verstärkung des Funktionssubstrates (Produktsubstrat) bei den verschiedenen Bearbeitungsschritten, insbesondere beim Rückdünnen des Funktionssubstrates. Als Substrate kommen insbesondere Wafer, entweder mit Abflachung ("flat") oder Einkerbung ("notch"), in Frage.

Als eigenständige Erfindung ist ein Produkt (beziehungsweise eine Substrat-Trägersubstrat-Kombination) vorgesehen, welches aus einem Trägersubstrat und einem Substrat besteht, die mit der erfindungsgemäßen Vorrichtung und/oder dem erfindungsgemäßen Verfahren ausgerichtet, kontaktiert und miteinander vorfixiert und/oder gebonded worden sind und sich insbesondere dadurch auszeichnen, dass der Durchmesser d2 des Trägersubstrats minimal geringer ist als der Durchmesser d1 des Produktsubstrats. Erfindungsgemäß wird damit sichergestellt, dass das Trägersubstrat während der Prozessierung des Produktsubstrats keinerlei Kontamination, Verschmutzung, ungewollter Behandlung etc. ausgesetzt wird und daher öfter wiederverwendet werden kann.

Obwohl sich die erfindungsgemäße Ausführungsform vor allem dazu eignet, ein, insbesondere vom Durchmesser d2 her kleineres, Trägersubstrat in Bezug auf ein, insbesondere vom Durchmesser d1 her größeres, Substrat auszurichten, kann die erfindungsgemäße Vorrichtung auch dazu genutzt werden, um Trägersubstrate, die größer oder gleich groß sind wie die zu bondenden Substrate, zueinander auszurichten.

Indem die Erfassungsmittel gegenüber dem Substrat und/oder gegenüber dem Trägersubstrat durch Rotationsmittel rotierbar und/oder gegenüber dem Substrat und/oder gegenüber dem Trägersubstrat durch eine Verstelleinrichtung in X- und/oder Y-Richtung parallel zur Kontaktierungsebene verstellbar sind, ist die Ausrichtung effizient und präzise ausführbar.

Gemäß einer vorteilhaften Ausführungsform der Erfindung ist vorgesehen, dass die Erfassungsmittel an einer zumindest abschnittsweise umfangsseitig zum Substrat und/oder Trägersubstrat anordenbaren, insbesondere abschnittsweise ringförmig ausgebildeten, Trägereinheit angebracht sind. Damit ist eine erfindungsgemäße Integration der Erfassungsmittel in effizienter Weise möglich.

Mit Vorteil ist die Trägereinheit zwischen der Trägersubstrataufnahme und der Substrataufnahme angebracht, insbesondere mit dazwischen angebrachten Kontaktierungsmitteln, vorzugsweise in Form einer Z-Verstelleinheit, und/oder mit dazwischen angebrachter Grundplatte. Auf diese Weise ist eine besonders effiziente Ausgestaltung der Erfindung vorgesehen.

Dabei ist es von Vorteil, wenn die Verstelleinrichtung in Weiterbildung der Erfindung, insbesondere unmittelbar, zwischen der Grundplatte und der Trägereinheit angebracht ist. Somit ist eine unmittelbare Einwirkung auf die Trägereinheit, insbesondere zusammen mit der daran angebrachten Substrataufnahme, denkbar.

Gemäß einer weiteren, vorteilhaften Ausführungsform der Erfindung ist vorgesehen, dass die Umfangskontur und die Umfangskontur, insbesondere gleichzeitig, mit denselben, insbesondere einem oder mehreren Erfassungsmitteln, vorzugsweise Mikroskopen, erfassbar sind. Auf diese Weise lässt sich die Anzahl der teuren Erfassungsmittel ohne Geschwindigkeitseinbußen reduzieren.

Die Ausrichtung eines Substrates kann erfindungsgemäß auch zu einem Substratstapel als Trägersubstrat erfolgen. Dabei versteht man unter einem Substratstapel eine Menge bereits bearbeiteter, beispielsweise rückgedünnter, Substrate, die, insbesondere permanent, miteinander gebonded sind. Erfindungsgemäß kann dieser Substratstapel, wenn er dick genug ist, als Trägersubstrat dienen.

Besonders bevorzugt ist die Verwendung einer mechanischen Ausrichtungseinrichtung (Verstelleinrichtung und Rotationsmittel) sowohl für das Substrat als auch für das Trägersubstrat in Verbindung mit einem optischen Distanzmesssystem. Hierbei ist es von besonderem Vorteil, wenn diese Ausrichtungseinrichtung in einer Anlage zum Bonden oder Vorfixieren der Substrate integriert angeordnet ist.

Die Erfindung erlaubt somit eine exakte, schnelle und kostengünstige Ausrichtung zweier Substrate (Substrat und Trägersubstrat) zueinander, ohne auf Ausrichtungsmarken Bezug nehmen zu müssen. Erfindungsgemäße Trägersubstrate können daher auf Ausrichtungsmarken verzichten, so dass diese günstiger herstellbar sind.

Außerdem ist durch die vorliegende Erfindung eine mehrmalige Verwendung des Trägersubstrats möglich, ohne dieses durch aufwändige und teure Prozesse reinigen zu müssen.

Darüber hinaus ergibt sich die Möglichkeit, die erfindungsgemäße Vorrichtung in einen Bonder einzubauen/zu integrieren.

Mit der vorliegenden Erfindung werden die unterschiedlichen Durchmesser der Substrate an mehreren Punkten des Umfangs (Umfangskonturen) berücksichtigt und eine genauere Positionierung ermöglicht, die bei anderen mechanischen und/oder optischen Positionierungen nicht möglich sind. Gleichzeitig wird eine schnellere Ausrichtung als bei (rein) mechanischer Ausrichtung ermöglicht.

Das der Erfindung zugrundeliegende Verfahren und die erfindungsgemäße Vorrichtung sind in der Lage, die erforderlichen Genauigkeiten, insbesondere <50µm, zu ermöglichen und insbesondere eine höhere Rotationsgenauigkeit am Umfang, die bei bisherigen mechanischen Verfahren ein Schwachpunkt ist, zu erreichen. Es können sehr genau Einkerbungen am Umfang der Substrate (sogenannte "notches") von Substrat und Trägersubstrat zugeordnet werden.

Mit besonderem Vorzug befinden sich die Einkerbungen, in einer solchen Position, dass sie von mindestens einem Erfassungsmittel detektiert werden. Jenes Erfassungsmittel, dessen Messrichtung parallel oder beinahe parallel, zur Substratnormalen ist, kann durch die Position der Einkerbungen besonders schnell eine rotatorische Missorientierung feststellen. Analoge Überlegungen gelten für Substrate mit flats oder jeder beliebigen anderen Einkerbung oder Abweichung von einer vorgegebenen Idealgeometrie des betreffenden Substrats, welche zur rotatorischen Ausrichtung herangezogen werden kann.

Das erfindungsgemäße Verfahren ist insbesondere ein dynamisches, optisches Scanverfahren mit Softwaregesteuerter Optimierung der erfassten/gemessenen Daten.

In einer vorteilhaften Ausführung der Erfindung ist vorgesehen, das Trägersubstrat und das Funktionssubstrat an jeweils an gesonderten, mechanisch bewegbaren Haltevorrichtungen (Substrataufnahme/Trägersubstrataufnahme) zu fixieren. Hierbei sind insbesondere Chucks mit Vakuumhalterung vorgesehen. Es können aber auch andere Halterungen, wie adhäsive Materialien, mechanisches Klemmen oder elektrostatische Halterungen vorgesehen sein. Ebenso können an Stelle des Trägersubstrates auch Produktionssubstrate vorgesehen werden. Auch bereits mehrfach gebondete oder rückgedünnte Mehrschichtsubstrate können mit diesem Verfahren justiert/ausgerichtet werden.

Vorteilshaft wird eines der beiden Substrate auf einer in z Richtung beweglichen Befestigungseinrichtung (insbesondere Trägersubstrataufnahme) fixiert. Das andere Substrat auf einen drehbaren Chuck (insbesondere Substrataufnahme). Dieser ist in einer mechanischen Verstelleinheit (insbesondere Trägereinheit) befestigt, die in x und y Richtung verstellbar ist. An/In dieser mechanischen Verstelleinheit befinden sich ein oder mehrere optische Scaneinheiten (Erfassungsmittel), die die beiden Substrate, insbesondere gleichzeitig, in einem schmalen Bandbereich in vertikaler Richtung erfasst (scannt). Dadurch entsteht ein Abstandsprofil, das gleichzeitig die Außengeometrie (Umfangskonturen) der beiden Substrate erfasst/misst. Dieses Abstandsprofil ergibt insbesondere den größten äußeren Durchmesser des jeweiligen Substrates als auch den Abstand der einzelnen Substrate an den Messpunkten oder Messabschnitten zueinander.

Vorteilshalber rotieren diese Scaneinheiten der Erfassungsmittel in der mechanischen Verstelleinheit in der oder parallel zu der Kontaktierungsebene, um eine Erfassung mehrerer Umfangsabschnitte der Umfangskonturen der Substrate zu ermöglichen. Durch die Rotation der Scaneinheiten ist es möglich die Außengeometrie der beiden Substrate zu vermessen und zugleich die Lage der beiden Substrate zueinander zu ermitteln. Die Rotation kann einen Vollkreis beschreiben oder auch nur Sektoren/Erfassungsabschnitte. Für weniger genaue Justieranforderungen kann auf die Rotation der Scaneinheiten verzichtet werden. Es ist auch möglich die Scaneinheiten nicht zu rotieren, sondern die beiden Substrate bei feststehenden Scaneinheiten zu rotieren.

Alternativ können auch mehrere Scaneinheiten stationär um die beiden Substrate angeordnet sein, insbesondere mindestens 3, um die Lage und Durchmesser der beiden Außenkonturen (oder softwaremäßig entsprechend idealisierten Kreise) zu determinieren. In diesem Fall kann eine Rotation von Substraten und/oder Scaneinheiten entfallen. Eine geringfügige Rotation eines Substrates relativ zum anderen ist in diesem Fall ausreichend, um die notches oder das flat in Rotationsrichtung in der Kontaktierungsebene auszurichten.

Alternativ können die Scaneinheiten von oben oder unten, ungefähr im rechten Winkel zur Substratebene angeordnet sein und die Kanten der Umfangskonturen der Substrate detektieren. Im Spezialfall handelt es sich um Mikroskope, die ein optisches Bild der beiden Waferkanten zur Messung und Auswertung liefern.

Eines oder mehrere dieser Mikroskope können erfindungsgemäß beweglich (rotierend um fixierte/stehende Substrate) oder stationär (mit rotierenden Substraten) angeordnet sein.

In einem weiteren Spezialfall sind mindestens drei Mikroskope stationär am Umfang über und/oder unter den Substraten angeordnet. Beide Umfangskanten sind über die Mikroskope sichtbar (ggf. unter umfokussieren aufgrund des Z-Abstandes (quer zur X- und Y-Richtung beziehungsweise Kontaktierungsebene), der die Tiefenschärfe übersteigen könnte. Das Substrat mit dem größeren Durchmesser, das die Sicht auf die Umfangskante des kleineren Substrats verdecken könnte, kann durch die Ausrichtungsmittel eine bestimmte Strecke bewegt und so sichtbar und positionierbar gemacht werden. Die Bildinformation der beiden Umfangskanten wird in eine Positionsinformation umgewandelt und die Substrate können zueinander präzise ausgerichtet werden.

Durch Software kann die notwendige Berechnung der Verstellwege der mechanischen Stellelemente (Ausrichtungsmittel) in X- und Y-Richtung sowie die notwendige Rotation der Substrate errechnet werden. Diese Berechnung und Messung kann während der Z Bewegung (Kontaktiermittel), also des mechanischen Zusammenfahrens der beiden Substrate, kontinuierlich gemessen und allenthalben korrigiert werden.

Durch dieses online-Messverfahren ist es möglich, eventuelle Abweichungen während oder nach dem Zusammenfügen der Substrate zu korrigieren oder durch Auseinenderbewegen und erneutes Ausrichten und Kontaktieren zu optimieren.

Durch die erfindungsgemäße Vorrichtung und das erfindungsgemäße Verfahren ist es möglich, auch stark unterschiedliche Substrate, wie unterschiedliche Durchmesser oder unterschiedliche Geometrie, zum Beispiel runde Substrate zu rechteckigen Substraten, genau auszurichten.

Besonders vorteilhaft ist es gemäß einer Weiterbildung der Erfindung, wenn das Substrat nach dem Kontaktieren rückgedünnt wird, wobei der Durchmesser d1 durch die Form des Querschnitts des Substrats an dessen Umfangskontur verringert wird, insbesondere auf d1 <= d2. Dadurch wird die einfache Weiterverarbeitung der Substrat-Trägersubstratkombination, insbesondere auf bekannten und standardisierten Anlagen, ermöglicht.

Dabei ist es von besonderem Vorteil, wenn das Substrat einen, insbesondere durch Vorsehen eines Kantenradius und/oder durch Zurückschleifen der Umfangskontur erzeugten, ringförmigen Absatz aufweist. Dieser ist auf einfache Art und Weise herstellbar und trägt zur weiteren Optimierung des erfindungsgemäßen Herstellprozesses bei.

Indem eine Ringbreite dR des Absatzes größer oder gleich der Differenz aus d1 und d2 ist, lässt sich der Durchmesser des Substrats auf den Durchmesser d2 des Trägerwafers oder kleiner verringern, so dass bei der Weiterverarbeitung eine optimale Unterstützung des Produktsubstrats gewährleistet ist.

Gemäß einer weiteren, vorteilhaften Ausführungsform der Erfindung ist es vorgesehen, dass beim Rückdünnen eine Dicke D₁ des Substrats bis zu oder über den Absatz verringert wird.

Die erfindungsgemäße Vorrichtung wird insbesondere dadurch weitergebildet, dass die Erfassungsmittel die Form des Querschnitts des Substrats an dessen Umfangskontur erfassend ausgebildet sind derart, dass das Rückdünnen des Substrats so steuerbar ist, dass der Durchmesser d1 verringert wird, insbesondere auf d1 <= d2. Durch die Erfassung der Form des Querschnitts, insbesondere eines Profils der Querschnittskontur von der Seite betrachtet, also entlang der Dicke D1 des Substrats, kann erfindungsgemäß insbesondere eine exakte Steuerung des Rückdünnprozesses erfolgen.

Soweit vorliegend und/oder in der anschließenden Figurenbeschreibung Vorrichtungsmerkmale offenbart sind, sollen diese auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1a: eine schematische Querschnittsansicht einer erfindungsgemäßen Vorrichtung in einer ersten Ausführungsform,
- Fig. 1b: eine schematische Aufsicht auf die Vorrichtung gemäß Fig. 1a,
- Fig. 2a: eine schematische Querschnittsansicht einer erfindungsgemäßen Vorrichtung in einer zweiten Ausführungsform,
- Fig. 2b: eine schematische Aufsicht auf die Vorrichtung gemäß Fig. 2a,
- Fig. 3a: eine schematische Querschnittsansicht eines Prozessschrittes einer Ausführungsform eines erfindungsgemäßen Produktes (Substrat-Trägersubstratkombination) vor dem Bondschritt,
- Fig. 3b: eine schematische Querschnittsansicht eines Prozessschrittes einer Ausführungsform eines erfindungsgemäßen Produktes nach dem Bondschritt,
- Fig. 3c: eine schematische Querschnittsansicht eines Prozessschrittes einer Ausführungsform eines erfindungsgemäßen Produktes nach dem Rückdünnen,
- Fig. 4a: eine schematische Querschnittsansicht eines Prozessschrittes einer Ausführungsform eines erfindungsgemäßen Produktes vor dem Bondschritt,
- Fig. 4b: eine schematische Querschnittsansicht eines Prozessschrittes einer Ausführungsform eines erfindungsgemäßen Produktes nach dem Bondschritt und
- Fig. 4c: eine schematische Querschnittsansicht eines Prozessschrittes einer Ausführungsform eines erfindungsgemäßen Produktes nach dem Rückdünnen.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

Die Figuren zweigen jeweils eine Vorrichtung und ein Verfahren, welche es ermöglichen, Substrate 2, 5 (oder Substratstapel) über Umfangskanten 2u, 5u zueinander auszurichten. Bei dem erfindungsgemäßen Verfahren handelt es sich um ein dynamisches, optisches Scanverfahren mit Softwareoptimierung der gemessenen Daten.

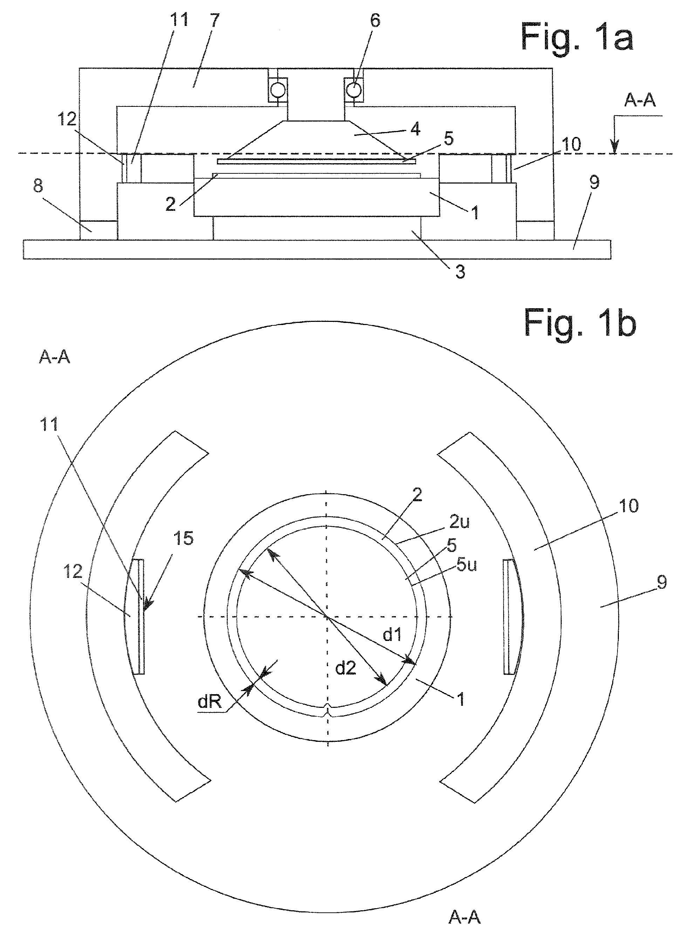

In Fig. 1a und 1b ist auf einer Substrataufnahme 1 (Chuck) ein Produktsubstrat als Substrat 2 fixiert. Die Substrataufnahme 1 ist über eine Verstelleinheit 3 (Kontaktierungsmittel) in Z Richtung verstellbar, also quer zu einer Kontaktierungsebene zwischen dem Substrat 2 und einem Trägersubstrat 5.

Oberhalb der Substrataufnahme 1 befindet sich ein weiterer Chuck (Trägersubstrataufnahme 4) mit dem darauf fixierten Trägersubstrat 5. Die Trägersubstrataufnahme 4 ist über eine Rotationsführung (Rotationsmittel 6) mit einer mechanischen Einheit (Trägereinheit 7) verbunden. Diese mechanische Trägereinheit 7 ist auf einer Grundplatte 9 über Führungen (Verstelleinrichtung 8 zur Verstellung in X- und Y- Richtung) verbunden. Diese Verstelleinrichtung 8 ermöglicht es, dass die mechanische Trägereinheit 7 in X und Y-Richtung bewegt werden kann, und zwar gesteuert über eine nicht dargestellte Steuerungseinrichtung.

Technisch gesehen kommt es nur auf die Möglichkeit an, eine Relativbewegung zwischen den Substraten 2, 5 zu bewirken.

Diese Trägereinheit 7 weist ein, insbesondere ringförmiges, vorzugsweise kreisrundes, Führungselement 10 auf. An dem Führungselement 10 befindet sich ein Entfernungsmesselement 11 (Erfassungsmittel). Die Erfassungsmittel sind vorteilshaft in der Kontaktierungsebene der beiden Substrate 2, 5 positioniert und durch das Entfernungsmesselement werden in einem bestimmten Winkelbereich alle Entfernungen gemessen/erfasst.

Dadurch entsteht in diesen gescannten Winkelbereich ein Entfernungsprofil, das der augenblicklichen Position der Scaneinheit (Erfassungsmittel) die Position der Substrate 2, 5 zuordnet.

Im Bereich des kreisrunden Führungselementes 10 weisen die Erfassungsmittel insbesondere zusätzliche Messmittel 12 auf. Die Messmittel 12 definieren die genaue Position der Scaneinheit 11 zum Umfang der Substrate 2, 5. Vorteilhaft befindet sich eine Auswerteeinheit der Messmittel 12 in den zugeordneten Entfernungsmesselementen integriert. Dies ist insbesondere von Vorteil, wenn mehrere Entfernungsmesselemente verwendet werden.

In einer eigenständigen, erfindungsgemäßen Ausführungsform wird dabei ein Trägersubstrat 5 verwendet, welches einen geringfügig kleineren Durchmesser d2 als der Durchmesser d1 des Produktsubstrats 2 besitzt. Damit wird das Trägersubstrat 5, vor allem die Trägersubstratkante (Umfangskante 5u), vor weiteren Prozessschritten geschützt, und das Trägersubstrat 5 ist, vorzugsweise mehrmals, ohne weiteren Reinigungsschritt verwendbar. Erfindungsgemäß können damit auch sehr teure und komplexe Trägersubstrate 5 vielfach verwendet werden.

Wird das Trägersubstrat 5, statt wie bisher in der Halbleiterindustrie üblich, nicht größer sondern kleiner (oder im Rahmen der Fertigungstoleranzen gleich groß) als das Produktsubstrat 2 verwendet, erübrigt sich jeder Reinigungsvorgang der Trägersubstratkante 5u und der Randbereich des Trägersubstrats 5 bleibt frei von Kontamination, da das Produktsubstrat 2 als Abdeckung des Trägersubstrats 5 und/oder der Trägersubstratkante 5u dient und dieses Trägersubstrat 5 den Einflüssen der Bearbeitung nicht ausgesetzt ist. Das Trägersubstrat 5 kann daher ohne Reinigungsschritt wiederverwendet werden.

Die Differenz zwischen dem (mittleren) Durchmesser d1 des Produktsubstrats 2 und dem (mittleren) Durchmesser d2 des Trägersubstrats 5 ist kleiner als 500µm, vorzugsweise kleiner 400µm, mit größerem Vorzug kleiner als 300µm, mit größtem Vorzug kleiner als 200µm, mit allergrößtem Vorzug kleiner als 100µm.

Im Falle von gleich großen Produkt- und Trägersubstratdurchmessern kann durch Fertigungstoleranzen auch ein Fall eintreten, bei dem der Durchmesser d2 des Trägersubstrats 5 minimal (innerhalb der Fertigungstoleranz) größer ist als der Durchmesser d1 des Produktsubstrats 2 ist. Wichtig ist erfindungsgemäß, dass ein Schutz der Trägersubstratkante 5u ausreichend gegeben ist durch die Abschattungswirkung der Produktsubstratkante 2u des, in diesem Falle, kleineren Produktsubstrats 2 (nicht eingezeichnet).

Um die geforderte Genauigkeit der Randüberdeckung zu erreichen, ist die Randübereinstimmung (Randüberstand des Produktsubstrats 2) insbesondere auf 5 µm bis 10 µm genau (konzentrisch). Mit anderen Worten weichen die Abstände der Umfangskanten 2u, 5u in radialer Richtung vom Zentrum der Substrate 2, 5 aus maximal um die obigen Werte voneinander ab.

Erfindungsgemäß ist das Trägersubstrat 5 um 0 µm bis 500 µm kleiner als das Produktsubstrat 2 ist, so dass die mechanische Unterstützung des mechanisch kritischen Randbereiches 2u des Produktsubstrates 2 ausreichend erhalten bleibt.

Aus Kosten- und Durchsatzgründen ist eine Positionierung an Passmarken im Inneren des Trägersubstrats 5 vorzugsweise nicht vorgesehen. Daher erfolgen erfindungsgemäß alle Justierungen zwischen strukturiertem Produkt- und unstrukturiertem Trägersubstrat nach den Substratkanten 2u, 5u der Substrate 2, 5.

Da die Substratkanten 2u, 5u der Substrate 2,5 mit erheblichen Fertigungstoleranzen behaftet sein können, ist eine genaue Positionierung besonders kritisch, insbesondere dann, wenn sehr genaue Positionierungen unterhalb von 20µm gefordert werden.

Es werden daher erfindungsgemäß Genauigkeiten von +/- 5µm bis. +/- 20µm und Rotationsgenauigkeiten von +/- 5/10 µm äquivalent am notch (falls vorhanden am Trägersubstrat), bzw. am flat gefordert.

Die Trägersubstrataufnahme 4 ist durch das Rotationsmittel 6 drehbar gelagert und über die Trägereinheit 7 mit der Verstelleinrichtung 8 verbunden, die eine translatorische Bewegung der Trägereinheit 7 und damit der Trägersubstrataufnahme 4 ermöglicht. In der Trägereinheit 7 befindet sich eine (oder mehrere) optische Scaneinheit 15, 15'.

Die Scaneinheit 15, 15' ist in der Lage, die Umfangskonturen 2u, 5u der beiden Substrate 2, 5 zumindest abschnittsweise zu erfassen, insbesondere scannen. Die Entfernungsmesseinrichtung 11 erlaubt dabei die, insbesondere kontinuierliche, Ermittlung des Abstandes vom Distanzmesssystem 11 zu den Umfangskonturen 2u, 5u.

Dadurch entsteht ein Abstandsprofil, das gleichzeitig die Außengeometrie der beiden Substrate 2, 5 vermisst/erfasst. Dieses Abstandsprofil ergibt sowohl den größten äußeren Durchmesser des jeweiligen Substrates 2, 5 als auch den Abstand der Umfangskonturen 2u, 5u der einzelnen Substrate 2, 5 zueinander. Bevorzugt rotieren die Scanneinheiten 15, 15' entlang der Führungselemente 10 in der mechanischen Vorrichtung.

Durch die Rotation der Scaneinheiten 15, 15' ist es möglich, die Substratkanten 2u, 5u der beiden Substrate 2, 5 zu vermessen und zugleich die Lage der beiden Substrate 2, 5 zueinander zu ermitteln. Die Scaneinheiten 15, 15' können sich entlang eines geschlossenen Kreises bewegen, sofern die Führung 10 geschlossen ist, oder nur entlang von Kreissegmenten 10, wie in der Ausführungsform in Fig. 1b gezeigt. Für weniger genaue Justieranforderungen kann auf die Rotation der Scaneinheiten 15, 15' verzichtet werden. Es ist auch möglich die Scaneinheiten 15, 15' nicht zu rotieren, sondern die beiden Substrate 2, 5 bei feststehenden Scaneinheiten 15, 15' zu rotieren, indem entsprechende Kontaktierungsmittel 3 Rotationseinheiten aufweisen.

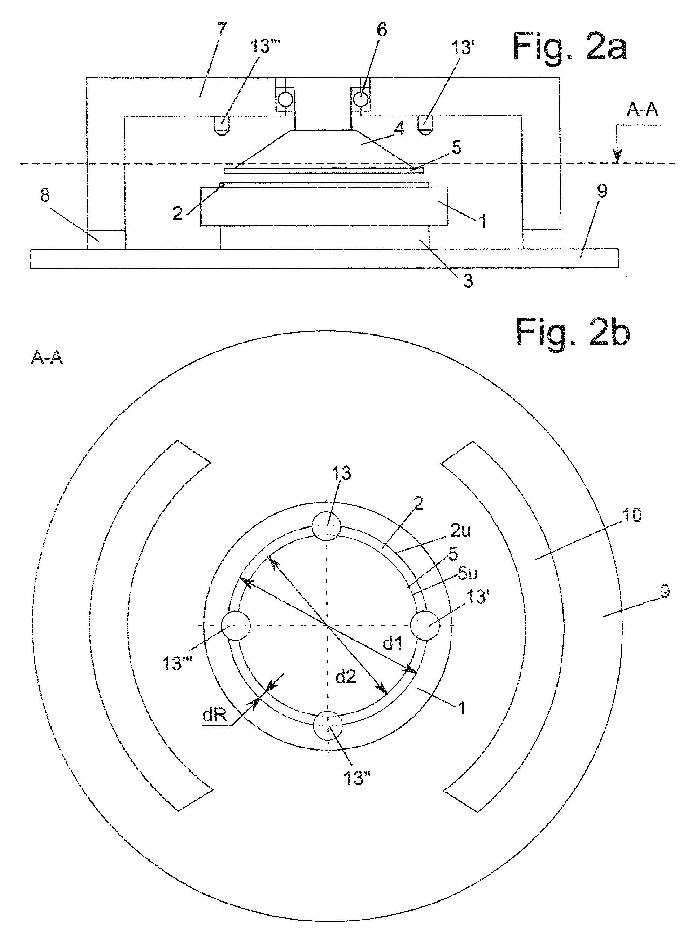

In der Ausführungsform gemäß Fig. 2a und 2b kann es sich bei den Scaneinheiten um Optiken 13, 13', 13", 13"' handeln, deren optische Achsen ungefähr im rechten Winkel zur Substratoberfläche des Substrats 2 steht. In einer speziellen Ausführungsform handelt es sich um Mikroskope, die ein optisches Bild der Substratkanten und somit der Umfangskonturen 2u, 5u zur Messung und Auswertung liefern.

Eines oder mehrere dieser Optiken 13, 13', 13", 13"' können wiederum beweglich (rotierend um die stehenden Substrate 2, 5) oder stationär (mit rotierenden Substraten 2, 5) angeordnet sein

In einem weiteren Spezialfall sind mindestens vier Optiken 13, 13', 13", 13"' stationär am Umfang über und/oder unter den Substraten 2,5 angeordnet. Beide Substratkanten 2u, 5u sind durch die Optiken 13, 13', 13", 13"' sichtbar (ggf. unter umfokussieren aufgrund des Z-Abstandes der die Tiefenschärfe übersteigen könnte).

In dieser Ausführungsform ist es vorteilhaft, wenn das Trägersubstrat 5 mit dem geringeren Durchmesser d2 im optischen Pfad zwischen den Optiken 13, 13', 13", 13"' und dem Substrat 2 mit dem größeren Durchmesser d1 liegt, damit für die Optiken 13, 13', 13", 13"' beide Umfangskonturen 2u, 5u bei entsprechender Ausrichtung der beiden Substrate 2, 5 zueinander gleichzeitig sichtbar sind.

Sollten die Optiken sensitiv für eine elektromagnetische Strahlung sein, für welche die verwendeten Substrate transparent sind, kann das Substrate 2 mit dem größeren Durchmesser d1 sich auch näher an der jeweiligen Optik befinden. Beispielhaft genannt seien Siliziumwafer, die für Infrarotstrahlung transparent sind.

Mathematisch kann die Justierung der beiden Substrate 2, 5 zueinander durch jede beliebige Ausgleichsrechnung, vorzugsweise durch die Methode der kleinsten Quadrate, durchgeführt werden. Die Optiken oder Distanzmesssysteme sind erfindungsgemäß vorzugsweise so auszuführen sind, dass die aufgenommenen Daten digitalisiert werden und an einen entsprechenden Computer weitergeleitet werden können.

Eine entsprechende Software im Computer (Steuerungseinrichtung) ist in der Lage, die X- und/oder Y- und/oder Rotationseinheiten so anzusteuern, dass eine kontinuierliche Anpassung der Ausrichtung der beiden Umfangskonturen 2u, 5u zueinander erfolgt und zwar solange, bis die entsprechende Ausgleichsrechnung der Software einen Parameter liefert, welcher ein Maß für die Genauigkeit der Ausgleichsrechnung ist, der einen vom Benutzer vorgegebenen Schwellwert unterschreitet.

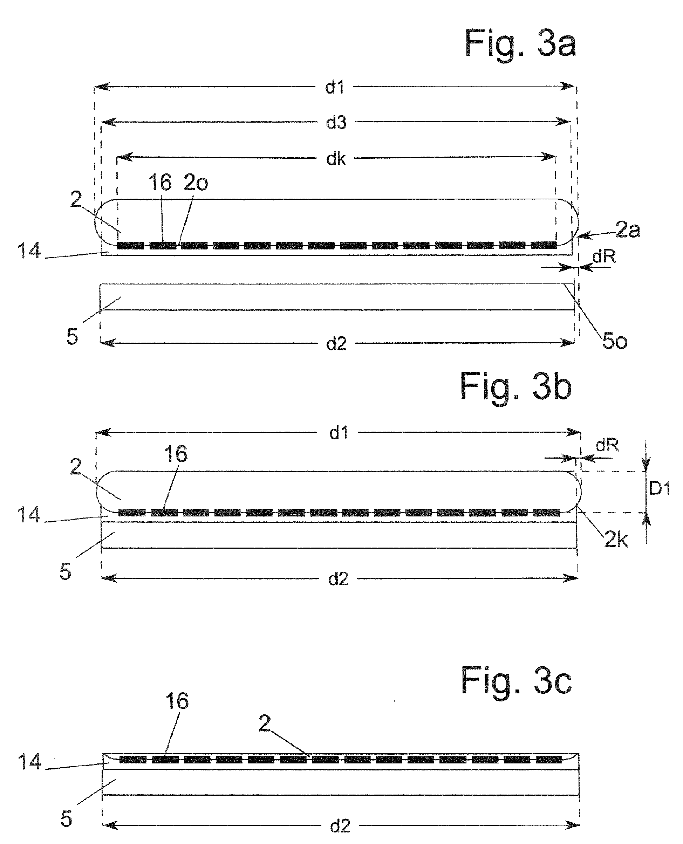

Die Figuren 3a-3b zeigen einen verkürzten Prozess zur Herstellung eines erfindungsgemäßen Produkts (Substrat-Trägersubstrat-Kombination), mit dem Trägersubstrat 5, dessen Durchmesser d2 zumindest vor dem Rückdünnprozess (Fig. 3a-3b) kleiner ist als der Durchmesser d1 des Substrats 2. Nach einem erfindungsgemäßen Ausrichtungs- und Bondprozess (Fig. 3b) erfolgt ein Rückdünnprozess des Substrats 2 (Fig. 3c).

Das Substrat 2 wird mit dem Trägersubstrat 5 durch eine Klebeschicht 14 verbunden, die vor dem Bonden auf das Substrat 2 aufgebracht wird, insbesondere mit einer Klebefläche mit einem Durchmesser d3, der zwischen dem Durchmesser d2 des Trägersubstrats 5 und dem Durchmesser d1 des Substrats 2 liegt, vorzugsweise dem Durchmesser d2 des Trägersubstrats 5 im Wesentlichen entspricht.

In der Ausführungsform gemäß Fig. 3 weist das Trägersubstrat 5 einen sehr kleinen Kantenradius auf, während das Substrat 2 einen sehr großen Kantenradius besitzt. In der erfindungsgemäßen Ausführungsform erhält man dadurch zwei Vorteile. Erstens trägt der relativ kleine Kantenradius des Trägersubstrats 5 dazu bei, dass eine das Substrat 2 nach Aufnahme auf dem Trägersubstrat 5 stützende Stützfläche 5o so weit wie möglich an eine Auflagekante 2k der Umfangskontur 2u reicht, was eine vorteilhafte Stützung des Produktsubstrats 2 durch das Trägersubstrat 5 zur Folge hat. Die Klebeschicht 14 hat keinen wesentlichen Einfluss auf die Stützung, zumal diese mindestens den Durchmesser d3 gleich dem Durchmesser d2 des Trägersubstrats 5 aufweist.

Durch den Kantenradius weist das Substrat 2 an seiner Umfangskontur zumindest an der Kontaktseite des Substrats 2 mit dem Trägersubstrat 5 einen ringförmigen Absatz 2a auf, der eine Ringbreite dR hat, die mindestens der Differenz der Durchmesser d2 und d1 entspricht. Der Absatz 2a zeichnet sich bei dieser Ausführungsform durch kontinuierliche Verringerung der Dicke D₁ des Substrats 2 in Richtung der Umfangskontur 2u und/oder durch kontinuierliche Verringerung des Durchmessers vom (maximalen) mittleren Durchmesser d1 bis zu einem Durchmesser dk an der Kontaktseite 2o aus. Der Absatz 2a kann insbesondere durch die Klebeschicht 14, insbesondere durch einen Durchmesser d3 der Klebeschicht 14, definiert sein.

Des Weiteren erlaubt der relativ große Kantenradius des Produktsubstrats 2, dass der Durchmesser d1 des Produktsubstrats 2 alleine durch das Rückdünnen und die Form des Querschnitts der Umfangskontur 2u an den Durchmesser d2 des Trägersubstrats 5 angepasst wird, indem das Rückschleifen bis mindestens zu dem Absatz 2a erfolgt. Nach einem erfindungsgemäßen Ausrichtungs- und Bondprozess (Fig. 3b) erfolgt ein Rückdünnprozess des Substrats 2 (Fig. 3c) mindestens bis über den Absatz der Umfangskontur 2u, also mindestens bis zum Absatz 2a'.

Es wäre auch denkbar, dass der Kantenradius des Produktsubstrats 2 sehr klein ist, was die nutzbare Fläche des Produktsubstrats 2, vor allem bei sehr großen Wafern, vergrößern würde und damit die Ausbeute von auf dem Produktsubstrat 2 vorgesehenen funktionalen Einheiten, beispielsweise Chips, 16 erhöhen würde.

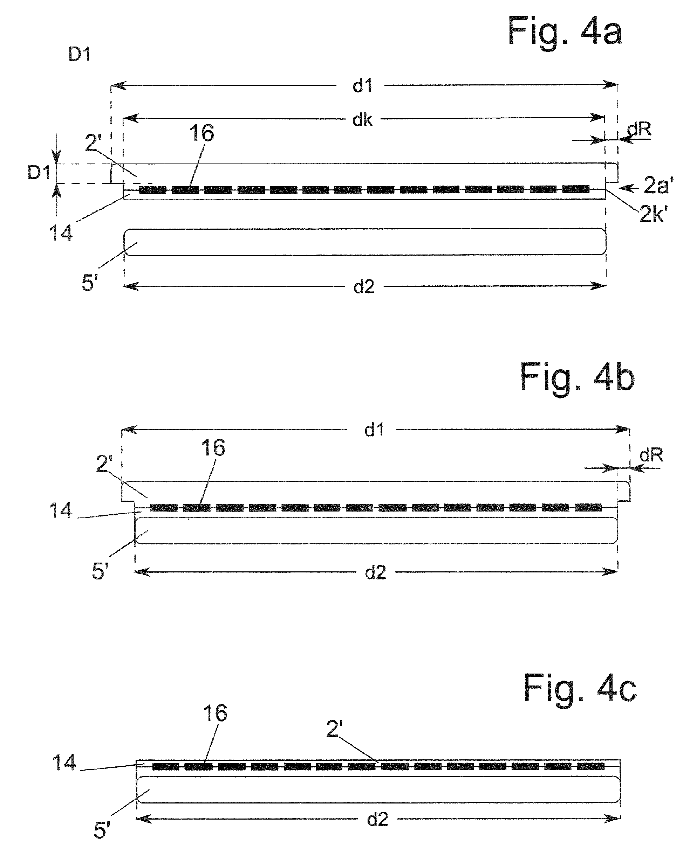

Die Figuren 4a-4b zeigen einen weiteren verkürzten Prozess eines erfindungsgemäßen Produkts (Substrat-Trägersubstrat-Kombination), mit einem Trägerwafer 5', dessen Durchmesser d2 kleiner ist als der Durchmesser d1 eines Substrats 2'. Der Rand des (Produkt-)substrats 2' wurde erfindungsgemäß an der Umfangskontur 2u um eine Ringbreite dR zurückgeschliffen, um einen Effekt ähnlich dem Effekt des größeren Kantenradius bei der Ausführung gemäß Figuren 3a bis 3c zu erreichen. Hierdurch entsteht ein ringförmiger Absatz 2a. Das Zurückschleifen wird insbesondere durch ein in der Industrie unter dem Namen "edge-trimming" bekanntes Verfahren erzeugt.

Der Durchmesser d2 des Trägerwafers 5' entspricht mit Vorzug gleich dem um die Ringbreite dR des Kreisrings reduzierten Durchmesser d1 des Substrats 2. Nach einem erfindungsgemäßen Ausrichtungs- und Bondprozess (Fig. 4b) erfolgt ein Rückdünnprozess des Substrats 2' (Fig. 4c) mindestens bis auf den zurückgeschliffenen Abschnitt der Umfangskontur 2u, also mindestens bis zum Absatz 2a'.

Beide erfindungsgemäßen Produkte haben die Eigenschaft, dass der Durchmesser d2 des Trägerwafers 5, 5' und der Durchmesser d1 des Substrats 2, 2' nach dem Rückdünnen eine geringere Differenz aufweisen, insbesondere annähernd gleich oder der Durchmesser d1 sogar kleiner als der Durchmesser d2 ist, indem auf Grund der Kantenform des Substrats 2, 2' der Rückdünnprozess zu einer Reduktion des Durchmessers d1 des Substrats 2, 2' führt.

Die Kantenformen der Substrate sind durch Semistandards festgelegt. Es gibt Substrate mit unterschiedlichen, für spezielle Aufgaben vorgesehenen Kantenprofilen. Diese Kantenprofile werden durch spezielle Maschinen hergestellt. Die Form der Kanten ist insbesondere von Bedeutung für die Chipausbeute. Um möglichst viele Chips auf einem Substrat prozessieren zu können, müssen auch auf den äußersten Randbereichen Chips hergestellt werden. Daher ist es erfindungsgemäß sinnvoll, die Kantengeometrie möglichst eckig, oder zumindest abgerundet mit möglichst geringen Rundungsradien herzustellen. Dadurch entsteht vorzugsweise ein Wafer mit möglichst großflächigem Nutzbereich.

Die unterschiedlichen Waferkantenprofile sind im SEMI Standard definiert. Die unterschiedlichen Waferkantenprofile können sehr komplizierte Formen annehmen und werden in den seltensten Fällen durch einen einzigen Parameter beschrieben. Erfindungsgemäß ist der Kantenradius als Parameter zu verstehen, der zu einer deutlichen Abrundung des Waferkantenprofils führt.

Für eine erfindungsgemäße Ausführungsform, in welcher der Produktwafer möglichst viele funktionale Einheiten besitzen soll, ist der charakteristische Kantenradius kleiner als 1mm, mit Vorzug kleiner als 0.5mm, mit größerem Vorzug kleiner als 0.1mm, mit größtem Vorzug kleiner als 0.001mm, mit allergrößtem Vorzug gleich 0mm.

Für eine erfindungsgemäße Ausführungsform, in welcher der Produktwafer durch Prozesse nach dem Bondvorgang in seiner Dicke reduziert wird, hat die Berechnung des charakteristischen Kantenradius anhand der Enddicke des Produktwafers beziehungsweise dem Durchmesser des Träger- und/oder Produktsubstrats zu erfolgen. Der charakteristische Kantenradius ist größer als 0mm, mit Vorzug größer als 0.001mm, mit größerem Vorzug größer als 0.1mm, mit größtem Vorzug größer als 0.5mm, mit allergrößtem Vorzug größer als 1 mm.

Für eine erfindungsgemäße Ausführungsform, in welcher der Trägerwafer den Produktwafer über eine möglichst große Fläche optimal stützen soll, ist der charakteristische Kantenradius des Trägerwafers kleiner als 1mm, mit Vorzug kleiner als 0.5mm, mit größerem Vorzug kleiner als 0.1 mm, mit größtem Vorzug kleiner als 0.001mm, mit allergrößtem Vorzug gleich 0mm.

### Bezugszeichenliste

- 1: Substrataufnahme
- 2, 2': Substrat
- 2o: Kontaktseite
- 2a, 2a': Absatz
- 2k, 2k': Auflagekante
- 3: Kontaktierungsmittel
- 4: Trägersubstrataufnahme
- 5, 5k': Trägersubstrat
- 2u, 5u: Umfangskonturen
- 5o: Stützfläche
- 6: Rotationsmittel
- 7: Trägereinheit
- 8: Verstelleinrichtung
- 9: Grundplatte
- 10: Führungselemente
- 11: Entfernungsmesselemente
- 12: Messmittel
- 13, 13', 13", 13"': Optiken
- 14: Klebeschicht
- 15, 15': Scaneinheit
- 16: Funktionale Einheiten
- d1, d2, d3, dk: Mittlere Durchmesser
- dR: Mittlere Ringbreite
- D₁: Dicke

## Patentansprüche

1. Vorrichtung zum Ausrichten und Kontaktieren eines flächigen Substrats (2, 2') mit einem Trägersubstrat (5, 5') für die Weiterverarbeitung des Substrats (2, 2') mit folgenden Merkmalen:
- eine Substrataufnahme (1) zur Fixierung des Substrats (2, 2'),
- eine Trägersubstrataufnahme (4) zur Fixierung des Trägersubstrats (5, 5'),
- Erfassungsmittel (11, 13) zur zumindest abschnittsweisen Erfassung einer Umfangskontur (2u) des auf der Substrataufnahme (1) fixierten Substrats (2, 2') und zumindest abschnittsweisen Erfassung einer Umfangskontur (5u) des auf der Trägersubstrataufnahme (4) fixierten Trägersubstrats (5, 5') bezogen auf eine Kontaktierungsebene des Substrats (2, 2') mit dem Trägersubstrat (5, 5'),
- Ausrichtungsmittel (6, 8) zur Ausrichtung des Substrats (2, 2') gegenüber dem Trägersubstrat (5, 5'), wobei die Ausrichtungsmittel (6, 8) durch Steuerungsmittel auf Basis der von den Erfassungsmitteln (11, 13) erfassten Umfangskonturen (2u, 5u) gesteuert werden und,
- Kontaktierungsmittel (3) zur Kontaktierung des gegenüber dem Trägersubstrat (5, 5') ausgerichteten Substrats (2, 2') mit dem Trägersubstrat, **gekennzeichnet durch** eine Entfernungsmesseinrichtung (11) zur Ermittlung des Abstandes der Entfernungsmesseinrichtung zu den Umfangskonturen (2u, 5u.

2. Vorrichtung nach Anspruch 1, wobei die Erfassungsmittel (11, 13) gegenüber dem Substrat (2, 2') und/oder gegenüber dem Trägersubstrat (5, 5') durch Rotationsmittel (6) rotierbar und/oder gegenüber dem Substrat (2, 2') und/oder gegenüber dem Trägersubstrat (5, 5') durch eine Verstelleinrichtung (8) in X-und/oder "Y-Richtung parallel zur Kontaktierungsebene verstellbar sind.

3. Vorrichtung nach einem der vorhergehenden Ansprüche, wobei die Erfassungsmittel (11, 13) einer zumindest abschnittsweise umfangsseitig zum Substrat (2, 2') und/oder Trägersubstrat (5, 5') anordenbaren, insbesondere abschnittsweise ringförmig ausgebildeten, Trägereinheit (7) angebracht sind.

4. Vorrichtung nach Anspruch 3, wobei die Trägereinheit (7) zwischen der Trägersubstrataufnahme (1) und der Substrataufnahme (4) angebracht ist, insbesondere mit dazwischen angebrachten Kontaktierungsmitteln (3), vorzugsweise in Form einer Z-Verstelleinheit, und/oder mit dazwischen angebrachter Grundplatte (9).

5. Vorrichtung nach Anspruch 2 und 4, wobei die Verstelleinrichtung (8), insbesondere unmittelbar, zwischen der Grundplatte (9) und der Trägereinheit (7) angebracht ist.

6. Vorrichtung nach einem der vorhergehenden Ansprüche, wobei die Umfangskontur (2u) und die Umfangskontur (5u), insbesondere gleichzeitig, mit denselben, insbesondere einem oder mehreren elektromagnetisch arbeitenden, Erfassungsmitteln (11, 13), vorzugsweise Mikroskopen, erfassbar sind.

7. Verfahren zum Ausrichten und Kontaktieren eines flächigen Substrats (2, 2') mit einem Trägersubstrat (5, 5') für die Weiterverarbeitung des Substrats (2, 2') mit folgenden Schritten, insbesondere folgendem Ablauf:
- zumindest abschnittsweise Erfassung einer Umfangskontur (2u) des auf einer Substrataufnahme (1) fixierten Substrats (2, 2') und zumindest abschnittsweise Erfassung einer Umfangskontur (5u) des auf einer Trägersubstrataufnahme (4) fixierten Trägersubstrats (5, 5') durch Erfassungsmittel (11, 13) bezogen auf eine Kontaktierungsebene des Substrats (2, 2') mit dem Trägersubstrat (5, 5'), wobei durch eine Entfernungsmesseinrichtung (11) den Abstand der Entfernungsmesseinrichtung (11) zu den Umfangskonturen (2u, 5u) ermittelt wird,
- Ausriahtung des Substrats (2, 2') gegenüber dem Trägersubstrat (5, 5') durch Ausrichtungsmittel (6, 8), wobei die Ausrichtungsmittel (6, 8) durch Steuerungsmittel auf Basis der von den Erfassungsmitteln (11, 13) erfassten Umfangskonturen (2u, 5u) gesteuert werden und
- Kontaktierung des gegenüber dem Trägersubstrat (5, 5') ausgerichteten Substrats (2, 2') mit dem Trägersubstrat (5, 5') durch Kontaktierungsmittel (3).

8. Verfahren nach Anspruch 7, bei dem die Erfassungsmittel (11, 13) zur Erfassung der Umfangskonturen (2u, 5u) gegenüber dem Substrat (2, 2') und/oder gegenüber dem Trägersubstrat (5, 5') durch Rotationsmittel (6) rotiert und/oder gegenüber dem Substrat (2, 2') und/oder gegenüber dem Trägersubstrat (5, 5') durch eine Verstelleinrichtung (8) in X- und/oder Y-Richtung parallel zur Kontaktierungsebene verstellt werden.

9. Verfahren nach Anspruch 7 oder 8, bei dem die Umfangskontur (2u) und die Umfangskontur (5u), insbesondere gleichzeitig, mit denselben, insbesondere einem oder mehreren elektromagnetisch arbeitenden, Erfassungsmitteln (11, 13), vorzugsweise Mikroskopen, erfasst werden.

10. Verfahren nach einem oder mehreren der Ansprüche 7 bis 9, bei dem die Erfassung an gleichmäßig verteilten, insbesondere jeweils mindestens drei, Positionen der Umfangskonturen (2u, 5u), insbesondere sequentiell durch Rotation der Erfassungsmittel gegenüber dem Substrat (2, 2') und/oder Trägersubstrat (5, 5') und/oder Anordnung mehrerer Erfassungsgeräte, vorzugsweise Mikroskope, entlang der Umfangskonturen (2u, 5u), erfolgt.

11. Verfahren nach einem oder mehreren der Ansprüche 7 bis 10, bei dem die Ausrichtung in einer X- und/oder Y- und/oder Rotationsrichtung erfolgt, wobei die Umfangskonturen (2u, 5u) zueinander konzentrisch oder äquidistant ausgerichtet werden, insbesondere mit einer Abstandsabweichung von weniger als 50µm, vorzugsweise weniger als 25 µm, noch bevorzugter weniger als 10µm, noch bevorzugter weniger als 5µm.

12. Verfahren nach einem oder mehreren der Ansprüche 7 bis 11, bei dem die Ausrichtung durch die Steuerungsmittel derart gesteuert wird, dass die Ausrichtung bei Unterschreiten eines festlegbaren Schwellenwerts für die Abstandsabweichungen oder die Summe der, insbesondere quadratischen, Abstandabweichungen oder die Summe von, insbesondere quadratischen, Abweichungen zu einem Mittelwert der Abstandsabweichungen beendet wird.

13. Verfahren nach einem oder mehreren der Ansprüche 7 bis 12, bei dem die Ausrichtung bis zur Kontaktierung kontinuierlich erfolgt.

## Claims

1. Device for aligning and bringing a large-area substrate (2, 2') into contact with a carrier substrate (5, 5') for the further processing of the substrate (2, 2') with the following features:
- A substrate holding means (1) for attaching the substrate (2, 2'),
- A carrier substrate holding means (4) for attaching the carrier substrate (5, 5'),
- Detection means (11, 13) for detection, at least in sections, of a peripheral contour (2u) of the substrate (2,2') attached to the substrate holding means (1) and detection, at least in sections, of a peripheral contour (5u) of the carrier substrate (5,5') attached to the carrier substrate holding means (4) relative to a contact plane of the substrate (2, 2') with the carrier substrate (5, 5'),
- Aligning means (6, 8) for aligning the substrate (2, 2') relative to the carrier substrate (5, 5'), whereby the aligning means (6, 8) are controlled by controlling means based on the peripheral contours (2u, 5u) detected by the detection means (11, 13), and
- Contacting means (3) for bringing the substrate (2, 2'), aligned relative to the carrier substrate (5, 5'), into contact with the carrier substrate (5, 5'), **characterized by** a distance-measuring-system (11) for determination of the distance from the distance-measuring-system to the peripheral contours (2u, 5u).

2. Device according to Claim 1, whereby the detection means (11, 13) relative to the substrate (2, 2') and/or relative to the carrier substrate (5, 5') can be rotated by rotational means (6) and/or can be adjusted relative to the substrate (2, 2') and/or relative to the carrier substrate (5, 5') by an adjustment system (8) in the X- and/or Y-direction parallel to the contact plane.

3. Device according to one of the preceding claims, whereby the detection means (11, 13) are attached to a carrier unit (7) that is designed in particular to be annular in sections and that can be arranged at least in sections on the peripheral side with respect to the substrate (2, 2') and/or the carrier substrate (5, 5').

4. Device according to Claim 3, whereby the carrier unit (7) is attached between the carrier substrate holding means (1) and the substrate holding means (4), in particular with contacting means (3) attached in-between, preferably in the form of a Z-adjustment unit, and/or with a base plate (9) attached in-between.

5. Device according to Claims 2 and 4, whereby the adjustment system (8) is attached, in particular directly, between the base plate (9) and the carrier unit (7).

6. Device according to one of the preceding claims, whereby the peripheral contour (2u) and the peripheral contour (5u) can be detected, in particular simultaneously, with the same, in particular one or more electromagnetically operating, detection means (11, 13), preferably microscopes.

7. Process for aligning and bringing a large-area substrate (2, 2') into contact with a carrier substrate (5, 5') for the further processing of the substrate (2,2') with the following steps, in particular the following sequence:
- Detection at least in sections of a peripheral contour (2u) of the substrate (2, 2') attached to a substrate holding means (1) and detection at least in sections of a peripheral contour (5u) of the carrier substrate (5, 5') attached to a carrier substrate holding means (4) by detection means (11, 13) relative to a contact plane of the substrate (2, 2') with the carrier substrate (5, 5'),
wherein by a distance-measuring-system (11) the distance from the distance-measuring-system to the peripheral contours (2u, 5u) is determined,
- Alignment of the substrate (2, 2') relative to the carrier substrate (5, 5') by alignment means (6, 8), whereby the alignment means (6, 8) are controlled by control means based on the peripheral contours (2u, 5u) detected by the detection means (11, 13), and
- Bringing into contact the substrate (2, 2'), aligned relative to the carrier substrate (5, 5'), with the carrier substrate (5, 5') by contacting means (3).

8. Process according to Claim 7, in which the detection means (11, 13) are rotated for detection of the peripheral contours (2u, 5u) relative to the substrate (2, 2') and/or relative to the carrier substrate (5, 5') by rotational means (6) and/or are adjusted relative to the substrate (2, 2') and/or relative to the carrier substrate (5, 5') by an adjustment system (8) in the X- and/or Y-direction parallel to the contact plane.

9. Process according to Claim 7 or 8, in which the peripheral contour (2u) and the peripheral contour (5u) are detected, in particular at the same time, with the same, in particular one or more electromagnetically operating, detection means (11, 13), preferably microscopes.

10. Process according to one or more of Claims 7 to 9, in which the detection on uniformly distributed, in particular in each case at least three, positions of the peripheral contours (2u, 5u) is carried out especially sequentially by rotation of the detection means relative to the substrate (2, 2') and/or carrier substrate (5, 5') and/or arrangement of several detection devices, preferably microscopes, along the peripheral contours (2u, 5u).

11. Process according to one or more of Claims 7 to 10, in which the alignment in an X- and/or Y-direction and/or rotational direction is carried out, whereby the peripheral contours (2u, 5u) are aligned equidistant or concentric with respect to one another, in particular at a gap deviation of less than 50 µm, preferably less than 25 µm, more preferably less than 10 µm, and more preferably less than 5 µm.

12. Process according to one or more of Claims 7 to 11, in which the alignment by the control means is controlled in such a way that the alignment is completed when the value drops below a determinable threshold value for the gap deviations or the sum of the in particular quadratic gap deviations, or the sum of in particular quadratic deviations from a mean value of the gap deviations.

13. Process according to one or more of the claims 7 to 12, wherein the alignment is continuous until contacting.

## Revendications

1. Dispositif d'alignement et de mise en contact d'un substrat plan (2, 2') avec un substrat porteur (5, 5') pour la transformation du substrat (2, 2') comprenant les attributs suivants :
- une réception de substrat (1) pour fixer le substrat (2, 2'),
- une réception de substrat porteur (4) pour fixer le substrat porteur (5, 5'),
- des moyens de détection (11, 13) pour détecter au moins par tronçons un contour périphérique (2u) du substrat (2, 2') fixé sur la réception de substrat (1) et pour détecter au moins par tronçons un contour périphérique (5u) du substrat porteur (5, 5') fixé sur la réception de substrat porteur (4), rapporté à un plan de mise en contact du substrat (2, 2') avec le substrat porteur (5, 5'),
- des moyens d'alignement (6, 8) pour aligner le substrat (2, 2') par rapport au substrat porteur (5, 5'), sachant que les moyens d'alignement (6, 8) sont commandés par des moyens de commande en se basant sur les contours périphériques (2a, 5u) détectés par les moyens de détection (11, 13) et,
- des moyens de mise en contact (3) pour mettre en contact le substrat (2, 2') aligné par rapport au substrat porteur (5, 5') avec le substrat porteur, **caractérisé par** un dispositif de mesure d'éloignement (11) pour calculer la distance du dispositif de mesure d'éloignement par rapport aux contours périphériques (2u, 5u).

2. Dispositif selon la revendication 1, dans lequel les dispositifs de détection (11, 13) peuvent tourner par rapport au substrat (2, 2') et/ou par rapport au substrat porteur (5, 5') par des moyens de rotation (6) et/ou sont mobiles par un dispositif de réglage (8) dans le sens X et/ou Y parallèle au plan de mise en contact par rapport au substrat (2, 2') et/ou par rapport au substrat porteur (5, 5').

3. Dispositif selon l'une des revendications précédentes, dans lequel les dispositifs de détection (11, 13) sont placés sur une unité porteuse (7) pouvant être agencée au moins par tronçons sur le pourtour en direction du substrat (2, 2') et/ou du substrat porteur (5, 5'), formée en particulier annulaire par tronçons.

4. Dispositif selon la revendication 3, dans lequel l'unité porteuse (7) est placée entre la réception de substrat (1) et la réception de substrat porteur (4), en particulier avec des moyens de mise en contact (3) placés entre, de préférence sous forme d'une unité de réglage en Z et/ou avec une plaque de base (9) placée entre,

5. Dispositif selon les revendications 2 et 4, dans lequel le dispositif de réglage (8) est placé, en particulier directement, entre la plaque de base (9) et l'unité porteuse (7),

6. Dispositif selon l'une des revendications précédentes, dans lequel le contour périphérique (2u) et le contour périphérique (5u) peuvent être détectés en particulier simultanément, avec les même, en particulier un ou plusieurs moyen(s) de détection (11, 13) travaillant de façon électromagnétique, de préférence des microscopes.

7. Procédé d'alignement et de mise en contact d'un substrat plan (2, 2') avec un substrat porteur (5, 5') pour la transformation du substrat (2, 2') comprenant les étapes suivantes, en particulier le déroulement suivant :
- détection au moins par tronçons d'un contour périphérique (2u) du substrat (2, 2') fixé sur une réception de substrat (1) et détection au moins par tronçons d'un contour périphérique (5u) du substrat porteur (5, 5') fixé sur une réception de substrat porteur (4) par des moyens de détection (11, 13) rapporté à un plan de mise en contact du substrat (2, 2') avec le substrat porteur (5, 5'), sachant qu'un dispositif de mesure de la distance (11) calcule la distance du dispositif de mesure de la distance (11) par rapport aux contours périphériques (2u, 5u),
- alignement du substrat (2, 2') par rapport au substrat porteur (5, 5') par des moyens d'alignement (6, 8), sachant que les moyens d'alignement (6, 8) sont commandés par des moyens de commande en se basant sur les contours périphériques (2u, 5u) détectés par les moyens de détection (11, 13) et
- mise en contact du du substrat (2, 2') aligné par rapport au substrat porteur (5, 5') avec le substrat porteur (5, 5') par des moyens de mise en contact (3).

8. Procédé selon la revendication 7, dans lequel les dispositifs de détection (11, 13) pour détecter les contours périphériques (2u, 5u) sont tournés par des moyens de rotation (6) par rapport au substrat (2, 2') et/ou par rapport au substrat porteur (5, 5') et/ou sont mobiles par un dispositif de réglage (8) dans le sens X et/ou Y parallèle au plan de mise en contact par rapport au substrat (2, 2') et/ou par rapport au substrat porteur (5, 5').

9. Procédé selon la revendication 7 ou 8, dans lequel le contour périphérique (2u) et le contour périphérique (5u) peuvent être détectés en particulier simultanément, avec les même, en particulier un ou plusieurs moyen(s) de détection (11, 13) travaillant de façon électromagnétique, de préférence des microscopes.

10. Procédé selon l'une ou plusieurs des revendications 7 à 9, dans lequel la détection s'effectue en particulier respectivement sur au moins trois positions des contours périphériques (2u, 5u) réparties uniformément, en particulier de façon séquentielle par rotation des moyens de détection par rapport au au substrat (2, 2') et/ou par rapport au substrat porteur (5, 5') et/ou agencement de plusieurs appareils de détection, de préférence des microscopes, le long des contours périphériques (2u, 5u).

11. Procédé selon l'une ou plusieurs des revendications 7 à 10, dans lequel l'alignement est effectué dans un sens X et/ou Y et/ou de rotation, sachant que les contours périphériques (2u, 5u) sont alignés de façon concentrique ou équidistante l'un à l'autre, en particulier avec un écart de distance inférieur à 50 µm, de préférence inférieur à 25 µm, plus encore de préférence inférieur à 10 µm, plus encore de préférence inférieur à 5 µm.

12. Procédé selon l'une ou plusieurs des revendications 7 à 11, dans lequel l'alignement est ainsi commandé par les moyens de commande que l'alignement est terminé en-deçà d'une valeur-seuil pouvant être prédéterminée pour les écarts de distance ou la somme d'écarts de distance en particulier quadratiques ou la somme d'écarts en particulier quadratiques par rapport à une valeur moyenne des écarts de distance.

13. Procédé selon l'une ou plusieurs des revendications 7 à 12, dans lequel l'alignement est continu jusqu'à la mise en contact.
